# EUROPEAN PATENT SPECIFICATION

(11) **EP 2 859 662 B1**
(45) Date of publication and mention of the grant of the patent: **27.04.2016**
(21) Application number: 13733974.3
(22) Date of filing: 20.06.2013
(51) Int. Cl.: H04B 3/50, G01R 19/00, H04B 1/58, H04B 3/46, H04L 12/24, H04L 29/08, H04L 29/06

(54) **AUTOMATIC CONFIGURATION OF A DEVICE FOR COMMUNICATION**
AUTOMATISCHE KONFIGURATION EINER VORRICHTUNG FÜR KOMMUNIKATION
CONFIGURATION AUTOMATIQUE D'UN DISPOSITIF DE COMMUNICATION

(30) Priority: 01.08.2012 EP 12178886
(43) Date of publication of application: 15.04.2015
(73) Proprietor: Siemens Aktiengesellschaft, 80333 München (DE)
(72) Inventor: KRISTIANSEN, Karstein, N-7051 Trondheim (NO)
(86) International application number: PCT/EP2013/062839
(87) International publication number: WO 2014/019763

(56) References cited:
- EP-A2- 0 639 916
- US-B1- 6 654 351
- US-B1- 7 058 075

## Description

### Field of invention

The present invention relates to a method and to an apparatus for configuring a device for reception of an electrical input signal, wherein the electrical input signal is a communication signal.

### Related prior art

An existing subsea installation, such as an oil/gas exploration system, may be based on old and slow communication standards and technologies. A number of subsea units may be connected to a communication network in order to exchange data for controlling the subsea units, such as pumps or measuring devices.

Document US 6,654,351 discloses a configurable multi-protocol vehicle communication circuit and method, wherein communication terminals and are placed in a high impedance state and the microprocessor senses a first voltage at the communication terminal and senses a second voltage at the communication terminal while in the high-impedance state.

Document EP 0 639 916 A2 discloses a system and method for connection of multiple protocol terminals, wherein a network port configurator device automatically configures a system having network workstations and corresponding network equipment of varies physical protocols.

Document US 7,058,075 B1 discloses a self-configuring interface for communication protocols, wherein an interface module having a network interface and to detect a voltage at an unused contact to identify a networking protocol for which the apparatus should be configured.

It has been observed that it is difficult to upgrade an existing communication network comprising a number of old subsea units.

There may be a need for a method and for an apparatus for configuring a device, in particular subsea communication device, for reception of an electrical input signal, thereby simplifying upgrading an existing communication network, in particular at a sea ground.

### Summary of the Invention

This need may be met by the subject matter according to the independent claims. Advantageous embodiments of the present invention are described by the dependent claims.

According to an embodiment of the present invention, it is provided a method for configuring a device for reception of an electrical input signal, the method comprising receiving a generated input signal complying to a predetermined communication technology, performing a measurement of the input signal, selecting, based on a result of the measurement, from a plurality of available communication technologies supported by the device the predetermined technology for receiving the input signal at the device, enabling the device such as to receive the input signal according to the predetermined communication technology, wherein the receiving of the generated input signal comprises receiving a voltage signal on a cable having wires galvanically separated from each other, wherein the performing the measurement of the input signal comprises testing which pair of wires of the cable carries the input signal, the pair being formed by a first wire and a second wire.

According to the invention, enabling the device to receive the input signal according to the predetermined communication technology comprises enabling a respective receiver or interface for the detected input signal and connecting the respective receiver or interface to the input signal.

The cable may for example have at least 4 wires, it may for example have between 4 and 5 wires galvanically separated from each other.

The device may in particular be or comprise a subsea unit, such as a pump, a compressor, a measuring device or the like, operable at a sea ground. The device may be located 1000 m - 4000 m below sea level, in particular at a sea ground.

The method may be performed during a gas/oil exploration application. The method may in particular be performed when the device replaces an old device which is a member of a communication network. In particular, the device may be configured for receiving an input signal when being a member of a communication network. One or more old devices may be replaced one by one with new devices which may be configured for the reception of the input signal according to embodiments of the present invention. In particular, the method may be performed during start up of the device.

Existing old devices or subsea units may be replaced one after each other during a time span of several years, until a complete upgrade of all units is achieved. Thereby, the new devices may be capable of more advanced or novel communication technologies. These advanced or novel communication technologies may provide higher data transfer rates, higher security and/or reliablity. The device which is being configured during the method according to embodiments of the present invention may be capable of communicating in both the old and also the new communication technology. Depending on the characteristics of the input signal to be supplied to the device the device may be configured regarding its communication interface to appropriately receive the input signal. In particular, the device (i.e. the new subsea unit which replaces the old subsea unit) may contain all possible physical interfaces and may be capable of handling all kinds of different communication protocols, including the old communication protocols and the new communication protocols.

In particular, during powering on the device a sense and select circuit (SASC) may receive the input signal (e.g. communication packages) and may decide based on the measurement, in particular voltage measurement, on the physical layer which type of communication the input signal complies to. Thereupon, the SASC unit or circuit may enable a correct receiver or interface for the detected input signal and may connect the correct receiver to the input signal. Whenever the device is enabled such as to receive the input signal according to the predetermined communication technology the device may keep the selected communication technology, until a next power on sequence. In particular, the enabling the device to receive the input signal according to the predetermined communication technology may only be performed during a start up or boot up sequence of the device.

The input signal may be a regular signal generated by another device during normal operation of the communication network. Alternatively, the input signal may be an intentionally generated input signal which may have particular characteristics in order to simplify the measurement or to simplify evaluating the measurement, in order to select the predetermined communication technology from the plurality of available communication technologies.

Thereby, a new communication infrastructure of the communication network may be upgraded step by step, while still the existing communication infrastructure is used by those devices which have only the capability to support the existing communication technology. According to embodiments of the present invention, old and new communication signalling is supported and the device which is being configured decides by itself which of the available communication signalling is to be used by the device depending on the plurality of available communication technologies supported by the device.

In an embodiment, generating the input signal may comprise supplying a voltage signal to a cable having between 4 and 5 wires galvanically separated from each other.

The input signal may be carried by the cable, in particular carried by two wires of the cable. Using a cable may simplify the supply of the input signal. Further, the measurement may be carried out by contacting one or more wires of the cable and detecting a voltage at the one or more wires of the cable.

The performing the measurement of the input signal comprises testing which pair of wires of the cable carries the input signal, the pair being formed by a first wire and a second wire.

Testing which pair of the wires of the cable carries the input signal may comprise measuring voltages between a number of pairs which may be formed from the wires of the cable. In particular, all permutations of possible pairs of wires may be checked for their voltages between two wires of one pair. Thereby, performing the measurement may be simplified.

According to an embodiment of the present invention, the performing the measurement of the input signal comprises comparing an electrical potential of the first wire and/or the second wire to a ground potential, wherein, if it is determined that the potential of one of the first wire or the second wire is the ground potential, the RS 232 communication technology is selected.

The RS 232 communication technology may use a non-differential signal for representing a logical true and a logical false. In particular logical false may be represented by having an electrical potential of -3 V at the first wire and by having an electrical potential of the earth potential at the second wire. Further in particular, a logical true value may be represented by having an electrical potential at the first wire of 10 V and having an electrical potential at the second wire of the earth potential. The method may further determine other types of communication technologies also using a non-differential signal by performing further tests on the electrical input signal.

Thereby, a simple manner of deciding that the input signal complies to the RS 232 communication technology is provided.

According to an embodiment of the present invention, the performing the measurement of the input signal comprises measuring a voltage, in particular for plural communication clock cycles, between the first wire and the second wire.

Nowadays a communication input signal may be largely represented by voltage signals. However, different communication technologies may utilize different voltage levels for representing logical false or logical true. In particular, the logical values may be represented by voltages which are as an absolute value below 20 V, in particular below 15 V. In particular, the communication technology may utilize a differential input signal for representing logical false and logical true. Thereby, a difference of electrical potentials between the first wire and the second wire may establish or define which logical value is transferred by the input signal. In particular, as is known in the art, the logical value may be transferred during clock cycles such that the logical value may be changed for each clock cycle. Thereby, the method is enabled to handle differential input signals and to differentiate between different differential input signals.

According to an embodiment of the present invention, if it is determined that the maximum absolute value of the voltage is below 3 V, the Ethernet communication technology is selected.

The voltage between the first wire and the second wire may alternate between -2.5 V and +2,5 V when the Ethernet communication technology is used. For example, the voltage of -2.5 V may represent a logical false value and a voltage of +2.5 V may represent a logical true value. However, the absolute value of the voltage may be ideally 2.5 V, thus may be below 3 V. Thereby, a simple procedure to determine that the Ethernet communication technology is used, is achieved.

According to an embodiment of the present invention, if it is determined that the maximum absolute value of the voltage is not below 3 V but below 6 V, the RS 422 communication technology is selected.

Also the RS 422 communication technology may utilize a differential signal for communication. However, in this case a voltage of -6 V may for example represent a logical false value and a voltage (between the first wire and the second wire) of +6 V may represent a logical true value. Thus, in any case the input signal may have a maximum absolute value of the voltage which is below 6 V (and not below 3 V), when the RS 422 communication technology is utilized.

Thereby, a simple procedure is provided for establishing that the input signal complies with the RS 422 communication technology.

Further, it may be checked whether the input signal is carried by 2 or 4 wires. This could e.g. be determined based on the format of the received input which may suggest 4 wire or 2 wire communication.

According to an embodiment of the present invention, if it is determined that the maximum absolute value of the voltage is above 6 V, the RS 485 communication technology is selected.

For example, a voltage of -7 V (between the first wire and the second wire) may represent a logical false value, while a voltage of +12 V (between the first wire and the second wire) may represent a logical true value, when the input signal complies to the RS 485 communication technology.

Further, it may be checked that the maximum absolute value of the voltage is below 12 V, in order to ensure that the input signal in fact complies to RS 485 communication technology (which requires that the voltage is not larger than 12 V in absolute terms).

According to an embodiment of the present invention, the available communication technologies and the predetermined communication technology comprise data package based protocols, in particular Ethernet, RS 485, RS 422, and/or RS 232.

In general, the method may support selection of different kinds of communication protocols which use differential signals or non-differential signals. Whenever a new communication technology evolves having particular voltage representations of logical false or logical true values, the skilled person will be able to provide another test or check, in order to detect the novel communication technology by performing one or more voltage measurements on the input signal.

Thereby, a large flexibility of the method for configuring a device is enabled, in particular also supporting novel communication technologies which are to be developed in the future.

According to an embodiment of the present invention, the generating the input signal comprises generating a particular signal pattern comprising a time sequence of logical true and logical false values, wherein the measurement is performed based on the signal pattern, wherein in particular a clock speed of the predetermined communication technology is considered when the measurement is performed or when a result is derived from the performed measurement, wherein the measurement is in particular performed across at least 10 clock cycles, in particular at least between 100 and 1000 clock cycles.

The particular signal pattern may be known in advance and may be utilized in order to evaluate the performed measurement. In particular, the signal pattern may comprise a sequence of logical true and false values. When knowing the signals of logical false and true values in advance, it may be easier to decide based on voltage measurements of the input signal which communication technology the input signal complies to.

Further, the clock speed (i.e. the minimal time span at which a logical value may change) may be known when the measurement is performed. Thereby, evaluation of the measurement may further be simplified. Further, taking into account a measurement across a number of clock cycles may further improve accuracy of the method.

According to an embodiment of the present invention, the method for configuring the device further comprises enabling a transceiver or interface of the device appropriate for the communication technology, actuating a switch to supply the input signal to the transceiver or interface.

Enabling the transceiver or device may comprise turning on the transceiver or device and/or configuring the transceiver or device or interface. The transceiver or the interface of the device may for example be embodied by an interface card or circuit which may be supported by the device but which may require to be switched on or to be enabled. Further, by actuating the switch the cable carrying the input signal may be connected to one or more input terminals of the transceiver or interface, thereby supplying the input signal to the transceiver or interface. Alternatively, the cable carrying the input signal may continuously be connected to all available transceivers or interfaces of the device in which case actuating the switch to supply the input signal to the transceiver or interface may be dispensed with.

Thereby, the device may be appropriately configured in order to receive and interpret the electrical input signal. Thereby, it is enabled to supply the input signal in a number of different communication protocols or technologies, wherein the device selects the appropriate technology the input signal complies to.

Thereby, upgrading a communication network or one or more communication devices comprised in the network, is enabled such that in particular a stepwise upgrade of communication technologies is enabled.

According to an embodiment of the present invention the actuating the switch comprises connecting the first wire and the second wire to input terminals of the enabled transceiver. Thereby, the input signal carried by the first wire and the second wire is supplied to the appropriated transceiver.

According to an embodiment of the present invention the actuating the switch comprises connecting a third wire of the cable and a fourth wire of the cable to output terminals of the enabled transceiver, in particular if it is determined that the RS 422 technology or the RS 485 technology uses four wires. Thereby, an output signal received or output by the appropriate transceiver may be supplied to the third wire and the fourth wire which may function as output wires of the communication cable.

According to an embodiment of the present invention, the method further comprises notifying the device about the communication technology to be used.

The device may utilize the communication technology which has been detected as the communication technology the input signal complies to, i.e. the predetermined communication technology, for further subsequent communications or output. Alternatively, the device may utilize a most recent or most advanced communication technology in order to communicate output signals of the device to other members of the communication network. In particular, the predetermined communication technology the input signal complies to may be different from a communication technology utilized by the device for outputting output signals to other members of the communication network. Thereby, communication speed may be increased, in order to improve the communication network.

It should be understood that features individually or in any combination disclosed, described, mentioned or employed for a method for configuring a device for reception of an electrical input signal may also be applied, used for or employed for an apparatus of configuring a device for reception of an input signal, according to embodiments of the present invention and vice versa.

According to an embodiment of the present invention it is provided an apparatus for configuring a device for reception of an electrical input signal, the apparatus comprising a measuring section adapted to perform a measurement of an input signal received at the apparatus and complying to a predetermined communication technology, a selection section adapted to select, based on a result of the measurement, from a plurality of available communication technologies supported by the device, the predetermined technology for receiving the input signal at the device, and a control section adapted to enable the device such as to receive the input signal according to the predetermined communication technology, wherein the receiving of the input signal comprises receiving a voltage signal on a cable having wires galvanically separated from each other, wherein the performing the measurement of the input signal comprises testing which pair of wires of the cable carries the input signal, the pair being formed by a first wire and a second wire.

According to the invention, enabling the device to receive the input signal according to the predetermined communication technology comprises enabling a respective receiver or interface for the detected input signal and connecting the respective receiver or interface to the input signal.

The apparatus may be configured or embodied as a circuit, in particular a sense and select circuit (SASC). The apparatus may be a portion of the device or may be a unit separate from the device. In particular, the device may at least comprise a number of transceivers or interfaces which support a number of different communication technologies.

The cable may have at least 4 wires, it may for example have between 4 and 5 wires.

The apparatus may be configured to perform the method according to any of the above described embodiments.

A further embodiment of the invention provides a subsea device comprising an apparatus as described above. By means of the apparatus, the subsea device may be capable of automatically selecting the communication technology suitable for processing a received electrical input signal. In a subsea installation comprising plural subsea devices, an upgrade to a new (and possibly faster) communication technology may thus be performed by substituting one subsea device after the other without losing the ability of the subsea devices to communicate with each other or with a central communication unit, e.g. a subsea control unit/module or the like. The subsea device itself may in some embodiments be a subsea control module or unit.

The features of the embodiments of the invention described above and further explained below may be combined with each other unless noted to the contrary.

### Brief Description of the Drawings

Embodiments of the present invention are now described with reference to the accompanying drawings. The invention is not limited to the illustrated or described embodiments.
Fig. 1 schematically illustrates a device which is being configured for reception of an electrical input signal according to an embodiment of the present invention;
Fig. 2 schematically illustrates a flow-chart of the selection algorithm for configuring a device according to an embodiment of the present invention; and
Fig. 3 schematically illustrates a device which is being configured for reception of an electrical input signal and for supplying an electrical output signal according to an embodiment of the present invention.

### Detailed Description

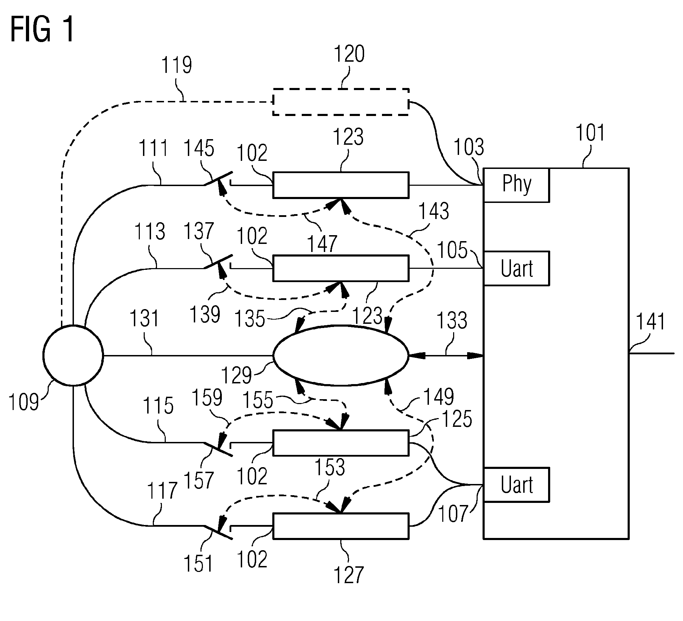

Fig. 1 schematically illustrates a device which is being configured for reception of an electrical input signal according to an embodiment of the present invention.
The device 101 illustrated in the Fig. 1 may for example comprise a pump or a compressor or a measuring unit, in order to support a subsea application, such as a gas/oil exploration procedure. The device 101 comprises hardware input terminals 103 (Phy), 105 (Uart) and 107 (Uart) for receiving a communication input signal which complies to different communication standards.

The device 101 is configured for reception of an electrical input signal 109 which may comply to one of a number of different communication technologies. Thereby, the input signal 109 may comply to an Ethernet technology which is represented schematically as a branch 111, may comply to a RS-232 technology as illustrated as a branch 113, may comply to a RS-485 communication technology which is represented by a branch 115 or may comply to a RS-422 communication technology as indicated by a branch 117. It is understood that the input signal 109 may comply to one or more other communication technologies as is schematically illustrated by a branch 119 representing differential or non-differential communication technologies.

The device 101 comprises a number of communication interfaces or transceivers, namely an Ethernet transceiver 121, a RS-232 transceiver 123, a RS-485 transceiver 125 and a RS-422 transceiver 127. The device may comprise more transceivers (illustrated as 120) for other technologies. These transceivers 121, 123, 125, 127 are connected to the respective input terminals 103, 105 and 107 of the device 101. Thereby, the device 101 is enabled to receive the input signal 109 in different representations, i.e. different communication technologies.

In order to appropriately configure the input device 101 to receive the input signal 109 which is represented or transmitted using a predetermined communication technology, such as the communication technology 111, 113, 115, 117 or 119, the device 101 comprises a sense and select circuit 129 which has measurement capabilities as well as configuring capabilities. In particular, via a line 131 the sense and select circuit 129 performs a measurement at the input signal 109, in order to select from the plurality of available communication technologies 121, 123, 125 and 127 and send a status signal corresponding to the selected communication technology to the device 101, wherein this status signal is indicated by a status line 133 carrying a status signal in Fig. 1.

In particular, the sense and select circuit 129 may in a first step determine a pair comprising a first wire and a second wire at which the input signal 109 is carried. Further on, the sense and select circuit 129 may carry out one or more voltage measurements at the determined pair comprising the first wire and the second wire.

As a next step the sense and select circuit 129 may carry out one or more measurements in order to determine, whether the input signal 109 is complying to a non-differential input signal. Thereby, in particular the sense and select circuit 129 may determine that the potential of one of the first wire or the second wire is the ground potential or earth potential. In this case, it is decided or selected by the sense and select circuit 129 to utilize the RS-232 transceiver 123 to receive the input signal 109. Therefore, the sense and select circuit 129 enables via a control line 135 the RS-232 transceiver 123 and further closes a switch 137 via a control signal 139, in order to supply the input signal 109 via the RS-232 transceiver 123 to the input terminal 105 of the device 101. Further, a status signal 133 may indicate that the RS-232 communication technology is being utilized.

Thereby, the device 101 is enabled to receive the input signal 109 and process the input signal and may, based on the processing the input signal 109, output one or more output signals at an output terminal 141.

In case, the sense and select circuit 129 determines that the input signal complies to a differential input signal a further test may be to measure a voltage between the first wire and the second wire at which the input signal 109 is carried. Thereby, different differential communication technologies may be distinguished from each other.

For example, the sense and select circuit 129 may determine that the maximum absolute value of the voltage between the first wire and the second wire is below 3 V, in which case the sense and select circuit 129 may enable via a signal line 143 the Ethernet transceiver 121 and may close a switch 145 via a control line 147, in order to supply the input signal 109 to the input terminal 103 of the device 101.

If on the other hand the sense and select circuit 129 determines that the voltage is below 6 V but not below 3 V, the sense and select circuit 129 may enable via a control line 149 the RS-422 transceiver 127 and further close a switch 151 via a control line 153 in order to supply the input signal 109 via the RS-422 transceiver 127 to the input terminal 107 of the device 101.

Finally, if the sense and select circuit 129 determines, that the maximum absolute value of the voltage between the first wire and the second wire is above 6 V (and in particular below 12 V) the sense and select circuit 129 may enable via the control line 155 the RS-485 transceiver 125 and may close the switch 157 via a control line 159, in order to supply the input signal 109 via the RS-485 transceiver 125 to the input terminal 107 of the device 101.

The following table 1 illustrates the different voltage levels for the different physical layers or communication technologies which are at least supported by the method and apparatus for configuring a device according to embodiments of the present invention.

**Table 1:**

| Physical layer | Voltage level | Differential |
|---|---|---|
| Ethernet | -2.5 V ... +2.5 V | yes |
| RS 485 | -5 V ... +12 V | yes |
| RS 422 | -6 V ... +6 V | yes |
| RS 232 | -3 V ... +15 V | no |

In particular, as is apparent from the Fig. 1 the device 101 comprises all physical interfaces and the sense and select circuit 129 configured the device 101 depending on the characteristics of the input signal 109 in order to enable the appropriate transceiver 121, 123, 125 and 127 which corresponds to the communication technology the input signal 109 complies to. In particular, the device 101 may keep the chosen communication interface until a next power on sequence. In particular, the selection of the appropriate interface may be performed only during a start up or boot of the device 101.

The method and the apparatus according to an embodiment of the present invention provide a solution which combines old and new communication signalling technologies to existing and new devices, such as device 101. In particular, the sense and select circuit (SASC) 129 detects the voltage level on the physical layer for incoming communication packages after powering on the device 101. Further, after a decision has been made regarding the type of communication protocol on the incoming signal 109, the SASC enables the transceiver corresponding to the input signal and closes one of the switches 145, 137, 157, 151, in order to supply the input signal 109 to the selected transceiver. After sensing and selecting the correct input, enabling the correct transceiver and connecting that transceiver to the input pins the SASC may tell the device 101 which type of communication is to be used for which the status line 133 is used.

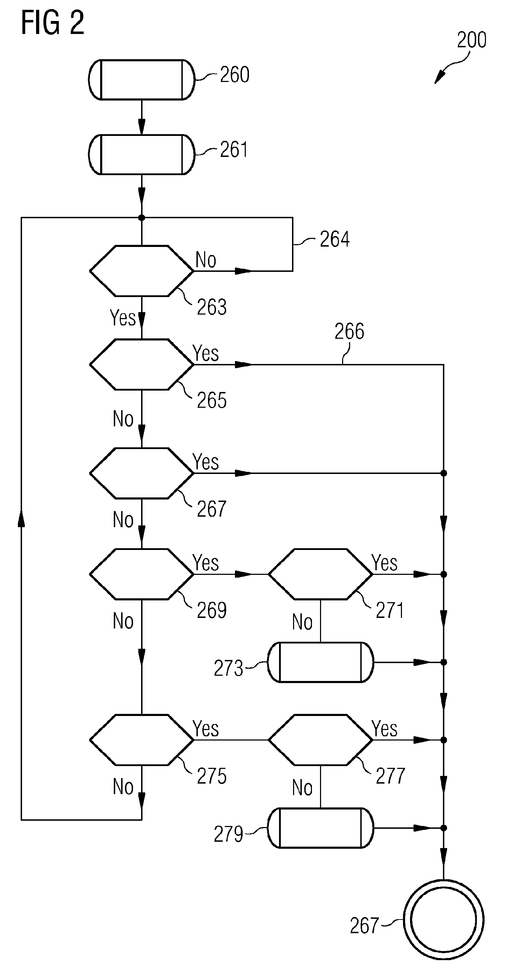

Fig. 2 illustrates a flow-chart 200 of a method for configuring a device according to an embodiment of the present invention. At the method step 260 the device is powered on. The method then proceeds to the method step 261 wherein an initiation phase is entered. In the decision step 263 it is checked whether there is any input voltage at any wire of the cable which is used for communication. If no voltage is detected, it is branched to a branch 264 which leads back to the method step 263. If there is a voltage detected, it is checked at a selection step 265, whether the voltage is compliant with the RS 232 technology. If this is the case, it is branched to the branch 266 which finally leads to enabling of the technology RS 232 and which leads to the normal operation 267.

If the RS 232 technology is not detected, it is checked in a decision step 267 whether the Ethernet technology is used by measuring the voltage between the first wire and the second wire. If this is the case, it is enabled the Ethernet technology and the normal operation 267 is reached. If no Ethernet technology is used, it is checked in a decision step 269, whether the RS 422 technology is used. If this is the case, it is checked in a further decision step 271 whether the RS 422 technology uses two wires in which case the two-wire RS 422 technology is enabled and the normal operation 267 is reached. If the RS 422 does not use two-wire communication, it is branched to the method step 273 in which the four-wire RS 422 technology is enabled and the normal operation 267 is reached.

If the test in the decision step 269 indicates that RS 422 is not being used, it is checked in a further decision step 275 whether the technology or the input signal, such as input signal 109 illustrated in Fig. 1, complies to the RS 485 technology. If this is the case, it is checked in a further decision step 277 whether the RS 485 uses two wires. If this is the case, the two-wire RS 485 technology is enabled and the normal operation 267 is reached. If this is not the case, the four-wire RS 485 technology is enabled in method step 279 and subsequently the normal operation 267 is reached.

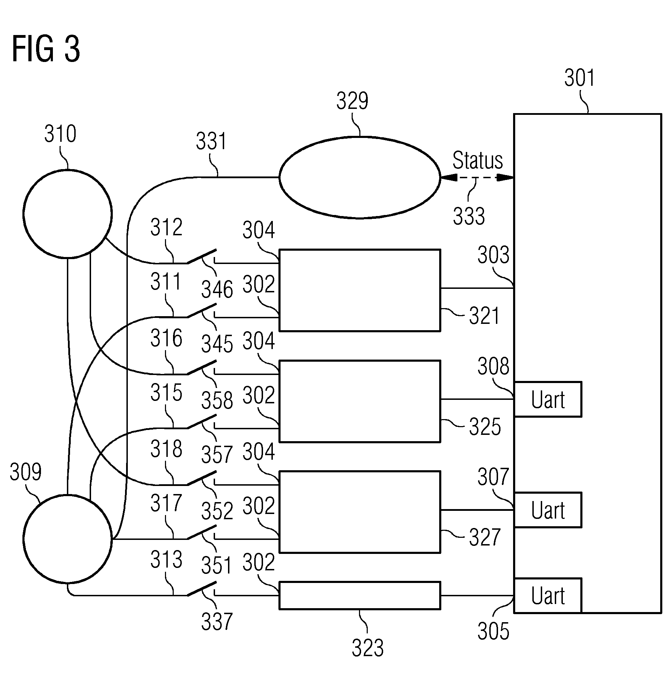

Fig. 3 schematically illustrates a device 301 which is being configured according to an embodiment of the present invention for receiving input as well as being configured to supplying output.

Thereby, a components or unit or entity which is similar in structure and/or function to a component, unit or entity illustrated in Fig. 1 is labelled with the same reference sign differing only in the first digit.

In Fig. 1 the transceivers 121, 123, 125, 127 and 120 are for simplicity only shown as having input terminals 102 for receiving the input signal 109. Thereby, when the respective transceiver is enabled one of the respective switches 145, 137, 157 or 151 is closed in order to supply the input terminal 109 to the selected and enabled transceiver.

The transceivers 321, 325, 327 and 323 illustrated in Fig. 3 also have the input terminals 302 in order to receive the input signal 309 when one of the respective switches 345, 357, 352 or 337 is closed after having selected the respective communication technology based on the measurements on the input signal 309.

It is shown in Fig. 3 that all inputs are wired together and also all outputs are wired together, since the whole concept is to be used for one input/output for different signal levels but not at the same time. The selection as also being described with reference to Fig. 1, which is carried out according to the scheme illustrated in Fig. 2, may be performed during start-up of the device 301, in particular after power is supplied to the device or processing unit 301.

In the initiation phase illustrated as method step 261 in Fig. 2 the sense and select circuit 129, 329 is enabled after powering on the device 301. Thereby, at this moment no switch of the input switches 345, 357, 351 or 337 is closed and the sense and select circuit 329 is listening to the input signal 309 and is sensing or measuring the voltage level of in particular the first wire and the second wire comprised in the communication cable, wherein the first wire and the second wire carry the input signal 309.

Thereupon, a selection phase is entered after the initiation phase. During the selection phase the system selects between one and only one of the possible communication technologies and enables the respective transceiver. Depending on the results of the performed measurements performed at the input signal 309 one of the input switches 337, 351, 357 or 345 is closed and the respective transceiver 323, 327, 325 or 321 is enabled to receive the input signal 309.

Thereby, the different states in which one of the input switches is closed are not illustrated for clarity.

Further, if it is detected that the Ethernet technology is used, also the output switch 346 is closed which thereby connects the output terminal 304 of the Ethernet transceiver 321 to the output wires 310.

The RS 422 technology as well as the RS 485 technology may be operated in two different variants, namely in a two-wire variant and a four-wire variant. When the two-wire variant is used, only the respective input switches, i.e. the input switch 351 or the input switch 357 is closed without closing the output switches 352 and 358.

If these technologies are operated in the four-wire variant also the output switches 352 or 358 are closed, in order to connect the output terminals 304 of the respective transceiver to the output wires 310 which are used to carrying an output signal which is output from the respective transceiver.

It should be noted that the term "comprising" does not exclude other elements or steps and "a" or "an" does not exclude a plurality. Also elements described in association with different embodiments may be combined. It should also be noted that reference signs in the claims should not be construed as limiting the scope of the claims.

## Claims

1. Method for configuring a device (101) for reception of an electrical input signal (109), the method comprising:
receiving a generated input signal (109) complying to a predetermined communication technology (111, 113, 115, 117, 119);
performing a measurement of the input signal (109);
selecting, based on a result of the measurement, from a plurality of available communication technologies (111, 113, 115, 117, 119) supported (121, 123, 125, 127) by the device (101) the predetermined technology for receiving the input signal (109) at the device (101);
enabling (155, 149, 143, 135) the device (101) such as to receive the input signal (109) according to the predetermined communication technology (111, 113, 115, 117, 119),
wherein receiving the generated input signal (109) comprises receiving a voltage signal on a cable having wires galvanically separated from each other,
**characterized in that** the performing of the measurement of the input signal (109) comprises testing which pair of wires of the cable carries the input signal, the pair being formed by a first wire and a second wire, and
wherein enabling the device to receive the input signal according to the predetermined communication technology comprises enabling a respective receiver or interface for the detected input signal and connecting the respective receiver or interface to the input signal.

2. Method according to claim 1, wherein the cable has at least 4 wires, and preferably has between 4 and 5 wires, galvanically separated from each other.

3. Method according to claim 1 or 2, wherein the performing the measurement of the input signal (109) comprises comparing an electrical potential of the first wire and/or the second wire to a ground potential,
wherein, if it is determined that the potential of one of the first wire or the second wire is the ground potential, the RS 232 communication technology is selected.

4. Method according to any of the preceding claims, wherein the performing the measurement of the input signal (109) comprises measuring a voltage, in particular for plural communication clock cycles, between the first wire and the second wire.

5. Method according to claim 4, wherein, if it is determined that the maximum absolute value of the voltage is below 3 V, the Ethernet communication technology is selected.

6. Method according to one of claims 4 or 5, wherein, if it is determined that the maximum absolute value of the voltage is not below 3 V but below 6 V, the RS 422 communication technology is selected.

7. Method according to one of claims 4 to 6, wherein, if it is determined that the maximum absolute value of the voltage is above 6 V, the RS 485 communication technology is selected.

8. Method according to one of the preceding claims, wherein the available communication technologies (111, 113, 115, 117, 119) and the predetermined communication technology comprise data package based protocols, in particular Ethernet, RS 485, RS 422, and RS 232.

9. Method according to one of the preceding claims, wherein the generating the input signal comprises generating a particular signal pattern comprising a time sequence of logical true and logical false values, wherein the measurement is performed based on the signal pattern,
wherein in particular a clock speed of the predetermined communication technology is considered when the measurement is performed or when a result is derived from the performed measurement,
wherein the measurement is in particular performed across at least 10 clock cycles, in particular at least between 100 and 1000 clock cycles.

10. Method according to one of the preceding claims, further comprising:
enabling (155, 149, 143, 135) a transceiver or interface (121, 123, 125, 127) of the device (101) appropriate for the communication technology (111, 113, 115, 117, 119);
actuating (147, 139, 159, 153) a switch (145, 137, 157, 151) to supply the input signal (109) to the transceiver or interface (121, 123, 125, 127).

11. Method according to the preceding claim, wherein the actuating the switch comprises connecting the first wire and the second wire to input terminals of the enabled transceiver.

12. Method according to one of claims 10 or 11, wherein actuating the switch comprises connecting a third wire of the cable and a fourth wire of the cable to output terminals of the enabled transceiver, in particular if it is determined that the RS 422 technology or the RS 485 technology uses four wires.

13. Method according to one of the preceding claims, further comprising:
notifying (133) the device (101) about the communication technology to be used.

14. Apparatus (129) for configuring a device (101) for reception of an electrical input signal (109), the apparatus comprising:
a measuring section adapted to perform a measurement of an input signal (109) received at the apparatus and complying to a predetermined communication technology (111, 113, 115, 117, 119);
a selection section adapted to select, based on a result of the measurement, from a plurality of available communication technologies (111, 113, 115, 117, 119) supported by the device (101) the predetermined technology (111, 113, 115, 117, 119) for receiving the input signal (109) at the device; and
a control section adapted to enable (155, 149, 143, 135) the device such as to receive the input signal (109) according to the predetermined communication technology,
wherein receiving the input signal (109) comprises receiving a voltage signal on a cable having wires galvanically separated from each other,
**characterized in that** the performing of the measurement of the input signal (109) comprises testing which pair of wires of the cable carries the input signal, the pair being formed by a first wire and a second wire, and
wherein enabling the device to receive the input signal according to the predetermined communication technology comprises enabling a respective receiver or interface for the detected input signal and connecting the respective receiver or interface to the input signal.

15. Apparatus according to claim 14, wherein the cable has at least 4 wires, and preferably has between 4 and 5 wires.

## Patentansprüche

1. Verfahren zum Konfigurieren einer Vorrichtung (101) zum Empfangen eines elektrischen Eingangssignals (109), wobei das Verfahren Folgendes umfasst:
Empfangen eines erzeugten Eingangssignals (109), das einer vorgegebenen Kommunikationstechnologie (111, 113, 115, 117, 119) entspricht,
Ausführen einer Messung des Eingangssignals (109),
Auswählen der vorgegebenen Technologie zum Empfangen des Eingangssignals (109) an der Vorrichtung (101) aus mehreren von der Vorrichtung (101) unterstützten (121, 123, 125, 127) verfügbaren Kommunikationstechnologien (111, 113, 115, 117, 119) auf der Grundlage eines Ergebnisses der Messung,
Aktivieren (155, 149, 143, 135) der Vorrichtung (101), so dass sie das Eingangssignal (109) gemäß der vorgegebenen Kommunikationstechnologie (111, 113, 115, 117, 119) empfängt,
wobei das Empfangen des erzeugten Eingangssignals (109) das Empfangen eines Spannungssignals auf einem Kabel mit galvanisch voneinander getrennten Adern umfasst,
**dadurch gekennzeichnet, dass**
das Ausführen der Messung des Eingangssignals (109) das Testen umfasst, welches Adernpaar des Kabels das Eingangssignal trägt, wobei das Paar von einer ersten und einer zweiten Ader gebildet wird, und
wobei das Aktivieren der Vorrichtung zum Empfangen des Eingangssignals gemäß der vorgegebenen Kommunikationstechnologie das Aktivieren eines entsprechenden Empfängers oder einer entsprechenden Schnittstelle für das erkannte Eingangssignal und das Verbinden des entsprechenden Empfängers oder der entsprechenden Schnittstelle mit dem Eingangssignal umfasst.

2. Verfahren nach Anspruch 1, bei dem das Kabel mindestens 4 Adern und vorzugsweise zwischen 4 und 5 Adern aufweist, die galvanisch voneinander getrennt sind.

3. Verfahren nach Anspruch 1 oder 2, bei dem das Ausführen der Messung des Eingangssignals (109) das Vergleichen eines elektrischen Potentials der ersten und/ oder der zweiten Ader mit einem Erdpotential umfasst,
wobei, wenn bestimmt wird, dass das Potential der ersten oder der zweiten Ader das Erdpotential ist, die Kommunikationstechnologie RS 232 ausgewählt wird.

4. Verfahren nach einem der vorhergehenden Ansprüche, bei dem das Ausführen der Messung des Eingangssignals (109) das Messen einer Spannung, insbesondere für mehrere Kommunikationstaktzyklen, zwischen der ersten und der zweiten Ader umfasst.

5. Verfahren nach Anspruch 4, bei dem, wenn bestimmt wird, dass der maximale Absolutwert der Spannung unter 3 V liegt, die Kommunikationstechnologie Ethernet ausgewählt wird.

6. Verfahren nach Anspruch 4 oder 5, bei dem, wenn bestimmt wird, dass der maximale Absolutwert der Spannung nicht unter 3 V, aber unter 6 V liegt, die Kommunikationstechnologie RS 422 ausgewählt wird.

7. Verfahren nach einem der Ansprüche 4 bis 6, bei dem, wenn bestimmt wird, dass der maximale Absolutwert der Spannung über 6 V liegt, die Kommunikationstechnologie RS 485 ausgewählt wird.

8. Verfahren nach einem der vorhergehenden Ansprüche, bei dem die verfügbaren Kommunikationstechnologien (111, 113, 115, 117, 119) und die vorgegebene Kommunikationstechnologie auf Datenpaketen basierende Protokolle, insbesondere Ethernet, RS 485, RS 422 und RS 232 umfassen.

9. Verfahren nach einem der vorhergehenden Ansprüche, bei dem das Erzeugen des Eingangssignals das Erzeugen eines bestimmten Signalmusters umfasst, das eine zeitliche Abfolge logisch wahrer und logisch falscher Werte umfasst, wobei die Messung auf der Grundlage des Signalmusters erfolgt,
wobei insbesondere eine Taktrate der vorgegebenen Kommunikationstechnologie berücksichtigt wird, wenn die Messung ausgeführt oder ein Ergebnis von der ausgeführten Messung abgeleitet wird,
wobei die Messung insbesondere über mindestens 10 Taktzyklen, insbesondere mindestens zwischen 100 und 1000 Taktzyklen ausgeführt wird.

10. Verfahren nach einem der vorhergehenden Ansprüche, das ferner Folgendes umfasst:
Aktivieren (155, 149, 143, 135) eines Transceivers oder einer Schnittstelle (121, 123, 125, 127) der Vorrichtung (101), der/ die für die Kommunikationstechnologie (111, 113, 115, 117, 119) geeignet ist,
Betätigen (147, 139, 159, 153) eines Schalters (145, 137, 157, 151) zum Bereitstellen des Eingangssignals (109) für den Transceiver oder die Schnittstelle (121, 123, 125, 127).

11. Verfahren nach dem vorhergehenden Anspruch, bei dem das Betätigen des Schalters das Verbinden des ersten und des zweiten Drahtes mit Eingangsanschlüssen des aktivierten Transceivers umfasst.

12. Verfahren nach Anspruch 10 oder 11, bei dem das Betätigen des Schalters das Verbinden einer dritten Ader des Kabels und einer vierten Ader des Kabels mit Ausgangsanschlüssen des aktivierten Transceivers umfasst, insbesondere wenn bestimmt wird, dass die Technologie RS 422 oder RS 485 vier Drähte benutzt.

13. Verfahren nach einem der vorhergehenden Ansprüche, das ferner Folgendes umfasst:
Benachrichtigen (133) der Vorrichtung (101) über die zu benutzende Kommunikationstechnologie.

14. Einrichtung (129) zum Konfigurieren einer Vorrichtung (101) zum Empfangen eines elektrischen Eingangssignals (109), wobei die Einrichtung Folgendes umfasst:
einen Messabschnitt, der so ausgelegt ist, dass er eine Messung eines Eingangssignals (109) ausführt, das an der Einrichtung empfangen wird und einer vorgegebenen Kommunikationstechnologie (111, 113, 115, 117, 119) entspricht,
einen Auswahlabschnitt, der so ausgelegt ist, dass er auf der Grundlage eines Ergebnisses der Messung aus mehreren von der Vorrichtung (101) unterstützten verfügbaren Kommunikationstechnologien (111, 113, 115, 117, 119) die vorgegebene Technologie (111, 113, 115, 117, 119) zum Empfangen des Eingangssignals (109) an der Vorrichtung auswählt, und
einen Steuerabschnitt, der so ausgelegt ist, dass er die Vorrichtung aktiviert (155, 149, 143, 135), so dass sie das Eingangssignal (109) gemäß der vorgegebenen Kommunikationstechnologie empfängt,
wobei das Empfangen des Eingangssignals (109) das Empfangen eines Spannungssignals auf einem Kabel mit galvanisch voneinander getrennten Adern umfasst,
**dadurch gekennzeichnet, dass**
das Ausführen der Messung des Eingangssignals (109) das Testen umfasst, welches Adernpaar des Kabels das Eingangssignal trägt, wobei das Paar von einer ersten und einer zweiten Ader gebildet wird, und
wobei das Aktivieren der Vorrichtung zum Empfangen des Eingangssignals gemäß der vorgegebenen Kommunikationstechnologie das Aktivieren eines entsprechenden Empfängers oder einer entsprechenden Schnittstelle für das erkannte Eingangssignal und das Verbinden des entsprechenden Empfängers oder der entsprechenden Schnittstelle mit dem Eingangssignal umfasst.

15. Einrichtung nach Anspruch 14, bei der das Kabel mindestens 4 Adern und vorzugsweise zwischen 4 und 5 Adern aufweist.

## Revendications

1. Procédé de configuration d'un dispositif (101) pour réception d'un signal d'entrée électrique (109), le procédé comprenant :
la réception d'un signal d'entrée (109) généré conforme à une technologie de communication (111, 113, 115, 117, 119) prédéterminée ;
l'exécution d'une mesure du signal d'entrée (109) ;
la sélection, sur la base d'un résultat de la mesure, parmi une pluralité de technologies de communication (111, 113, 115, 117, 119) disponibles supportées (121, 123, 125, 127) par le dispositif (101), de la technologie prédéterminée pour recevoir le signal d'entrée (109) au niveau du dispositif (101) ;
l'activation (155, 149, 143, 135) du dispositif (101) de façon à recevoir le signal d'entrée (109) selon la technologie de communication (111, 113, 115, 117, 119) prédéterminée,
dans lequel la réception du signal d'entrée (109) généré comprend la réception d'un signal de tension sur un câble ayant des fils galvaniquement séparés l'un de l'autre,
**caractérisé en ce que**
l'exécution de la mesure du signal d'entrée (109) comprend le test de quelle paire de fils du câble transporte le signal d'entrée, la paire étant formée par un premier fil et un deuxième fil, et
dans lequel l'activation du dispositif pour recevoir le signal d'entrée selon la technologie de communication prédéterminée comprend l'activation d'un récepteur ou d'une interface respectif(ve) pour le signal d'entrée détecté et la connexion du récepteur ou de l'interface respectif(ve) au signal d'entrée.

2. Procédé selon la revendication 1, dans lequel le câble a au moins 4 fils, et préférablement a entre 4 et 5 fils, galvaniquement séparés les uns des autres.

3. Procédé selon la revendication 1 ou 2, dans lequel l'exécution de la mesure du signal d'entrée (109) comprend la comparaison d'un potentiel électrique du premier fil et/ou du deuxième fil à un potentiel de terre,
dans lequel, s'il est déterminé que le potentiel de l'un du premier fil ou du deuxième fil est le potentiel de terre, la technologie de communication RS 232 est sélectionnée.

4. Procédé selon l'une quelconque des revendications précédentes, dans lequel l'exécution de la mesure du signal d'entrée (109) comprend la mesure d'une tension, en particulier pour des cycles d'horloge de communication multiples, entre le premier fil et le deuxième fil.

5. Procédé selon la revendication 4, dans lequel, s'il est déterminé que la valeur absolue maximum de la tension est inférieure à 3 V, la technologie de communication Ethernet est sélectionnée.

6. Procédé selon la revendication 4 ou 5, dans lequel, s'il est déterminé que la valeur absolue maximum de la tension n'est pas inférieure à 3 V mais inférieure à 6 V, la technologie de communication RS 422 est sélectionnée.

7. Procédé selon l'une des revendications 4 à 6, dans lequel, s'il est déterminé que la valeur absolue maximum de la tension est supérieure à 6 V, la technologie de communication RS 485 est sélectionnée.

8. Procédé selon l'une des revendications précédentes, dans lequel les technologies de communication (111, 113, 115, 117, 119) disponibles et la technologie de communication prédéterminée comprennent des protocoles basés sur des paquets de données, en particulier Ethernet, RS 485, RS 422, et RS 232.

9. Procédé selon l'une des revendications précédentes, dans lequel la génération du signal d'entrée comprend la génération d'un motif particulier de signal comprenant une séquence temporelle de valeurs logiques vraies et logiques fausses, dans lequel la mesure est exécutée sur la base du motif de signal,
dans lequel en particulier une fréquence d'horloge de la technologie de communication prédéterminée est prise en compte lorsque la mesure est exécutée ou lorsqu'un résultat est dérivé de la mesure exécutée,
dans lequel la mesure est en particulier exécutée sur au moins 10 cycles d'horloge, en particulier au moins entre 100 et 1 000 cycles d'horloge.

10. Procédé selon l'une des revendications précédentes, comprenant en outre :
l'activation (155, 149, 143, 135) d'un émetteur-récepteur ou d'une interface (121, 123, 125, 127) du dispositif (101) approprié(e) à la technologie de communication (111, 113, 115, 117, 119) ;
l'actionnement (147, 139, 159, 153) d'un commutateur (145, 137, 157, 151) pour délivrer le signal d'entrée (109) à l'émetteur-récepteur ou à l'interface (121, 123, 125, 127).

11. Procédé selon la revendication précédente, dans lequel l'actionnement du commutateur comprend la connexion du premier fil et du deuxième fil à des bornes d'entrée de l'émetteur-récepteur activé.

12. Procédé selon l'une des revendications 10 ou 11, dans lequel l'actionnement du commutateur comprend la connexion d'un troisième fil du câble et d'un quatrième fil du câble à des bornes de sortie de l'émetteur-récepteur activé, en particulier s'il est déterminé que la technologie RS 422 ou la technologie RS 485 utilise quatre fils.

13. Procédé selon l'une des revendications précédentes, comprenant en outre :
la notification (133) du dispositif (101) quant à la technologie de communication à utiliser.

14. Appareil (129) de configuration d'un dispositif (101) pour réception d'un signal d'entrée électrique (109), l'appareil comprenant :
une section de mesure adaptée à exécuter une mesure d'un signal d'entrée (109) reçu au niveau de l'appareil et conforme à une technologie de communication (111, 113, 115, 117, 119) prédéterminée ;
une section de sélection adaptée à sélectionner, sur la base d'un résultat de la mesure, parmi une pluralité de technologies de communication (111, 113, 115, 117, 119) disponibles supportées par le dispositif (101), la technologie prédéterminée (111, 113, 115, 117, 119) pour recevoir le signal d'entrée (109) au niveau du dispositif ; et
une section de commande adaptée à activer (155, 149, 143, 135) le dispositif de façon à recevoir le signal d'entrée (109) selon la technologie de communication prédéterminée,
dans lequel la réception du signal d'entrée (109) comprend la réception d'un signal de tension sur un câble ayant des fils galvaniquement séparés l'un de l'autre,
**caractérisé en ce que**
l'exécution de la mesure du signal d'entrée (109) comprend le test de quelle paire de fils du câble transporte le signal d'entrée, la paire étant formée par un premier fil et un deuxième fil, et
dans lequel l'activation du dispositif pour recevoir le signal d'entrée selon la technologie de communication prédéterminée comprend l'activation d'un récepteur ou d'une interface respectif(ve) pour le signal d'entrée détecté et la connexion du récepteur ou de l'interface respectif(ve) au signal d'entrée.

15. Appareil selon la revendication 14, dans lequel le câble a au moins 4 fils, et préférablement a entre 4 et 5 fils.
